# EUROPEAN PATENT APPLICATION

(11) **EP 3 104 578 A1**
(43) Date of publication of application: **14.12.2016**
(21) Application number: 16170557.9
(22) Date of filing: 20.05.2016
(51) Int. Cl.: H04L 29/08, G06F 11/20, G06F 3/06

(54) **METHOD AND ASSOCIATED APPARATUS FOR MANAGING A STORAGE SYSTEM**

(30) Priority: 12.06.2015 TW 104119060
(71) Applicant: Synology Incorporated, Taipei 103 (TW)
(72) Inventor: Huang, Yi-Chan, 111 Taipei City (TW)
(74) Representative: Becker Kurig Straus

(57) **Abstract**

A method for managing a storage system and an associated apparatus are provided, where the storage system includes a plurality of subsystems, the method is applied to a subsystem of the plurality of subsystems, and the subsystem is coupled to another subsystem of the plurality of subsystems through a coupling circuit (101). The method includes: utilizing a main circuit (105-1) of the subsystem to obtain a characteristic parameter of the coupling circuit (101) from the coupling circuit (101), in which a network module (130-1) of the subsystem is coupled to the main circuit (105-1), and the network module (130-1) is utilized for providing the main circuit (105-1) with a network service; and according to the characteristic parameter, utilizing the main circuit (105-1) to control the subsystem to exchange information with the other subsystem through the network module (130-1), to automatically establish the storage system as a high availability cluster.

## Description

The present invention relates to a high availability (HA) cluster, such as the high availability cluster of a data storage system adopting the Serial Attached Small Computer System Interface (Serial Attached SCSI or SAS) technique.

Network services are a feature of our daily lives. Malfunctioning of elements, human error and system failure may cause the server to malfunction and/or interrupt the service. The operating cost of a network company may increase accordingly.

Some high availability clusters have made efforts to maintain some types of network services, but these measures may introduce additional issues. For example, before a high availability cluster is established, two servers arranged to implement the high availability cluster require manual operations to establish the connection between the two servers. More particularly, the administrator of the high availability cluster must set the identification information (e.g. an Internet Protocol (IP) address or a name for indicating the other server) of one server in another server. Further, errors may occur in the manual setting; for example, the two servers should have been established as nodes N1 and N2, respectively, but the administrator mistook node N3 for node N2, and inputted data of node N3 to node N1. Neither of the two servers can identify this kind of error, and if the administrator is also not informed, the related costs will increase.

In view of the above, there is a need for a novel method and related scheme to solve the aforementioned issues without introducing any negative side effects.

This in mind, the application aims at providing an apparatus and an associated method in order to solve the abovementioned problems.

This is achieved by an apparatus and an associated method for managing a storage system according to claims 1 and 7. The dependent claims pertain to corresponding further developments and improvements.

As will be seen more clearly from the detailed description following below, the claimed apparatus includes a main circuit and a network module. The main circuit is installed in a subsystem (e.g. a first subsystem) within the plurality of subsystems, and coupled to another subsystem (e.g. a second subsystem) within the plurality of subsystems through a coupling circuit of the storage system. The main circuit is arranged to control operations of the subsystem (e.g. the first subsystem), in which the main circuit obtains a characteristic parameter of the coupling circuit from the coupling circuit. The network module is coupled to the main circuit, and arranged to provide a network service for the main circuit, in which by utilizing the characteristic parameter, the main circuit controls the subsystem to exchange information with the other subsystem (e.g. the second subsystem) through the network module. This automatically establishes the storage system as a high availability (HA) cluster.

In addition, the claimed method includes: utilizing a main circuit of the subsystem (e.g. the first subsystem) to obtain a characteristic parameter of the coupling circuit from the coupling circuit, in which a network module of the subsystem is coupled to the main circuit, and the network module is utilized for providing the main circuit with a network service; and according to the characteristic parameter, utilizing the main circuit to control the subsystem to exchange information with the other subsystem (e.g. the second subsystem) through the network module, to automatically establish the storage system as a high availability (HA) cluster.

In the following, the invention is further illustrated by way of example, taking reference to the accompanying drawings. Thereof:
Fig. 1 is a diagram illustrating an apparatus for managing a storage system according to an embodiment of the present invention;
Fig. 2 is a flowchart illustrating a method for managing a storage system according to an embodiment of the present invention;
Fig. 3 is a diagram illustrating a control scheme associated with the method shown in Fig. 2 according to an embodiment of the present invention;
Fig. 4 is a diagram illustrating a control scheme associated with the method shown in Fig. 2 according to another embodiment of the present invention;
Fig. 5 is a diagram illustrating a control scheme associated with the method shown in Fig. 2 according to yet another embodiment of the present invention; and
Fig. 6 is a diagram illustrating a control scheme associated with the method shown in Fig. 2 according to still another embodiment of the present invention.

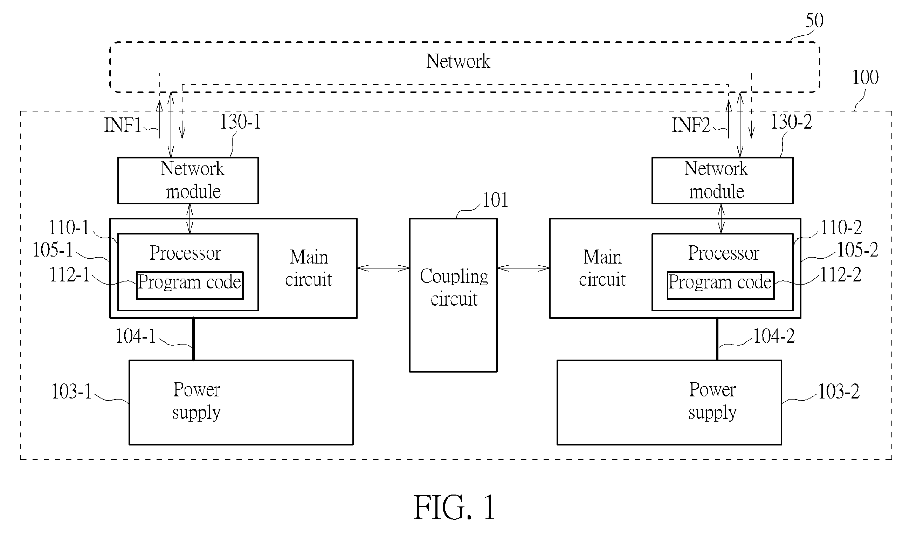

Fig. 1 is a diagram illustrating an apparatus 100 for managing a storage system according to an embodiment of the present invention, in which the storage system may include a plurality of subsystems, and the apparatus 100 may include at least one portion (e.g. part or all) of the plurality of subsystems. At least one subsystem within the plurality of subsystems may include at least one storage device (e.g. a plurality of hard disk drives), for providing access services based on the aforementioned at least one storage device. For example, the apparatus 100 may be one or more control circuits in some of the plurality of subsystems, such as one or more integrated circuits (ICs). In another example, the apparatus 100 may be a whole subsystem of the plurality of subsystems. In another example, the apparatus 100 may be at least two subsystems in the plurality of electronic devices. In another example, the apparatus 100 may be the whole storage system. According to this embodiment, the storage system may be established as a high availability (HA) cluster. For example, the storage system may be a data storage system implemented with a server technique, such as the Serial Attached Small Computer System Interface or SAS technique, or the SAS expander technique. Further, the plurality of subsystems may be servers, or headers implemented with the SAS expander technique and enclosures thereof.

As shown in Fig. 1, the apparatus 100 may include main circuits 105-1 and 105-2 and a coupling circuit 101, in which the main circuit 105-1 may include a processor 110-1, and the main circuit 105-2 may include a processor 110-2. The network modules 130-1 and 130-2 are coupled to the main circuits 105-1 and 105-2, respectively. The power supplies 103-1 and 103-2 are coupled to the main circuits 105-1 and 105-2 through the power traces 104-1 and 104-2, respectively. According to this embodiment, the main circuit 105-1 is used to control operations of one subsystem (e.g. a first subsystem) of the plurality of subsystems, and the main circuit 105-2 is used to control another subsystem (e.g. a second subsystem) of the plurality of subsystems. Further, the network module 130-1 may couple the subsystem (e.g. the first subsystem) to the network 50, and the network module 103-2 may couple the other subsystem (e.g. the second subsystem) to the network 50, in which the network modules 130-1 and 130-2 may provide network services for the main circuits 105-1 and 105-2, respectively. The processor 110-1 for executing the program code 112-1 may control operations of the main circuit 105-1, and the processor 110-2 for executing the program code 112-2 may control operations of the main circuit 105-2. For example, the main circuit 105-1 and 105-2 may be implemented as motherboards of servers, respectively. In another example, the main circuit 105-1 and 105-2 may be implemented as motherboards of headers, respectively.

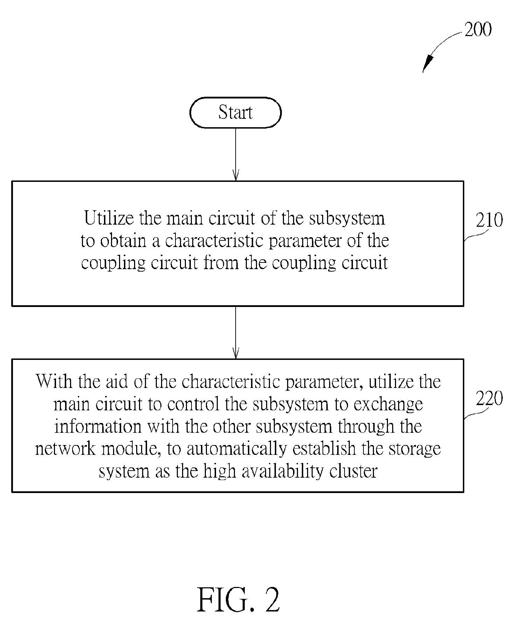

Fig. 2 is a flowchart illustrating a method 200 for managing a storage system according to an embodiment of the present invention. The method 200 may be applied to the main circuits 105-1 and 105-2 of the apparatus 100, and more particularly, the processor 110-1 for executing the program code 112-1 and the processor 110-2 for executing program code 112-2. For better understanding, the method is applied to the subsystem (especially the main circuit 105-1 and the network module 130-1 thereof) in the following descriptions; however, this is merely for illustrative purposes. The method may also be applied to the other subsystem (especially the main circuit 105-2 and the network module 130-2 thereof), and the method is described as follows.

In Step 210, the apparatus 100 utilizes the main circuit 105-1 of the subsystem to obtain a characteristic parameter of the coupling circuit 101 from the coupling circuit 101, in which the network module 130-1 of the subsystem is coupled to the main circuit 105-1, and the network module 130-1 is used to provide network services for the main circuit 105-1.

In Step 220, with the aid of the characteristic parameter, the apparatus 100 may utilize the main circuit 105-1 to control the subsystem to exchange information (e.g. the information INF1 and INF2) with the other subsystem through the network module 130-1, to automatically establish the storage system as the high availability cluster.

In practice, the aforementioned exchanged information (e.g. any of the information INF1 and INF2) may be transmitted by utilizing at least one packet (e.g. one or more packets). Further, examples of the information INF1 may include, but are not limited to: the Internet Protocol (IP) address of the subsystem, the program version information (e.g. the version number of the program code 112-1) of the subsystem, and the equipment information (e.g. the information of various elements in the subsystem, such as the information of the main circuit 105-1, the processor 110-1 and the network module 130-1) of the subsystem. Examples of the information INF2 may include, but are not limited to: the IP address of the other subsystem, the program version information (e.g. the version number of the program code 112-1) of the other subsystem, and the equipment information (e.g. the information of various elements in the other subsystem, such as the information of the main circuit 105-2, the processor 110-2, and the network module 130-2 information) of the other subsystem.

According to this embodiment, one of the subsystem and the other subsystem may transmit a packet to the other of the subsystem and the other subsystem through the network modules 130-1 and 130-2 and the network 50, to allow the other of the subsystem and the other subsystem to determine whether the subsystem and the other subsystem belong to the same system or not, in which the packet carries the characteristic parameter of the coupling circuit 101.

One of the subsystem and the other subsystem may be the subsystem, and the other of the subsystem and the other subsystem may be the other subsystem. More particularly, in Step 210, when the subsystem boots up, the apparatus 100 may utilize the main circuit 105-1 to obtain the characteristic parameter from the coupling circuit 101. Further, the other subsystem (more particularly the main circuit 105-2 therein) may obtain the characteristic parameter from the coupling circuit 101, and then compare the characteristic parameter obtained from the coupling circuit 101 with the characteristic parameter from the packet, in order to determine whether the other subsystem and the subsystem belong to the same system or not. When the other subsystem determines that the other subsystem and the subsystem belong to the same system (e.g. the main circuit 105-2 in the other subsystem detects that the characteristic parameter obtained from the coupling circuit 101 is identical to the characteristic parameter from the packet), the other subsystem (more particularly the main circuit 105-2 therein) may transmit another packet to the subsystem through the network modules 130-1 and 130-2 and network 50, to confirm whether the other subsystem and the subsystem belong to the same system. The other packet transmitted to the subsystem from the other subsystem carries corresponding confirmation information to indicate the detection result "the characteristic parameter obtained from the coupling circuit 101 is identical to the characteristic parameter obtained from the packet". Hence, the subsystem may be aware that the other subsystem and the subsystem belong to the same system, and automatically perform operations of exchanging information, e.g. the subsystem sends its IP address, the program version information and equipment information to the other subsystem; and the other subsystem sends its IP address, program version information and equipment information to the subsystem. The subsystem may automatically establish the high availability cluster, without the need of the manual settings required by the related arts. In Step 210, when the subsystem boots up, the apparatus 100 may utilize the main circuit 105-1 to obtain the characteristic parameter from the coupling circuit 101; and in Step 220, the apparatus 100 may utilize the main circuit 105-1 to automatically trigger the subsystem to establish the high availability cluster according to the characteristic parameter.

In another example, the one of the subsystem and the other subsystem may be the other subsystem, and the other of the subsystem and the other subsystem may be the subsystem. More particularly, when the other subsystem boots up, the other subsystem (especially the main circuit 105-2 therein) may obtain the characteristic parameter from the coupling circuit 101. In Step 220, the apparatus 100 may utilize the main circuit 105-1 to compare the characteristic parameter obtained from the coupling circuit 101 with the characteristic parameter obtained from the packet, to determine whether the subsystem and the other subsystem belong to the same system or not. When the subsystem determines that the subsystem and the other subsystem belong to the same system (e.g. the main circuit 105-1 of the subsystem detects that the characteristic parameter obtained from the coupling circuit 101 is identical to the characteristic parameter obtained from the packet), the apparatus 100 may utilize the main circuit 105-1 to control the subsystem to send another packet to the other subsystem through the network module 130-1 and 130-2 and network 50, in order to confirm whether the subsystem and the other subsystem belong to the same system. The other packet sent from the subsystem to the other subsystem carries corresponding confirmation information to indicate the detection result "the characteristic parameter obtained from the coupling circuit 101 is identical to the characteristic parameter obtained from the packet". The other subsystem may therefore be aware that the subsystem and the other subsystem belong to the same system, and may automatically perform the operation of exchanging information, e.g. the other subsystem sends its IP address, program version information and equipment information to the subsystem; and the subsystem sends its IP address, program version information and equipment information to the other subsystem. This allows the other subsystem to automatically establish the high availability cluster without the need of manual settings. In Step 210, in response to the trigger of the other subsystem, the apparatus 100 may utilize the main circuit 105-1 to obtain the characteristic parameter from the coupling circuit 101; and in Step 220, through the network module 130-1, the apparatus 100 may utilize the main circuit 105-1 to respond to the other subsystem according to the characteristic parameter, to make the other subsystem automatically establish the high availability cluster according to the characteristic parameter.

According to some embodiments, the packet may be a broadcast packet. According to other embodiments, the packet may be a multicast packet.

According to some embodiments, the coupling circuit 101 may include a non-volatile memory. The non-volatile memory stores a unique identification (UID), in which the characteristic parameter may include the unique identification. According to other embodiments, the characteristic parameter may include a serial number (SN) of the coupling circuit 101.

According to some embodiments, the main circuit 105-1 and the network module 130-1 may be located in a specific management module within a set of management modules (e.g. a set of headers) of the storage system corresponding to the subsystem, and the main circuit 105-2 and the network module 130-2 may be located in another management module within the set of management modules corresponding to the other subsystem. Further, the coupling circuit 101 may be located in an expander module of the storage system, in which the expander module may be used to install a set of shared storage devices of the storage system, such as a set of hard disk drives. For example, the main circuit 105-1 and the network module 130-1 may be located in a first header corresponding to the subsystem, and the main circuit 105-2 and the network module 130-2 may be located in a second header corresponding to the other subsystem, in which the expander module may be an enclosure.

According to some embodiments, the coupling circuit 101 may be a back panel of the expander module. For example, the apparatus 100 may include the expander module. According to other embodiments, the coupling circuit 101 may be a back panel, which is not necessarily installed in the expander module. For example, the apparatus 100 may include the back panel.

According to some embodiments, the method may also be applied to any subsystem within the plurality of subsystems except for the subsystem (as well as the main circuit and network module thereof), such as the other subsystem (as well as the main circuit 105-2 and the network module 130-2 thereof).

According to some embodiments, the number of the plurality of subsystems may be larger than two, in which the method may also be applied to any subsystem within the plurality of subsystems except for the subsystem and the other subsystem (as well as the main circuits and network modules thereof).

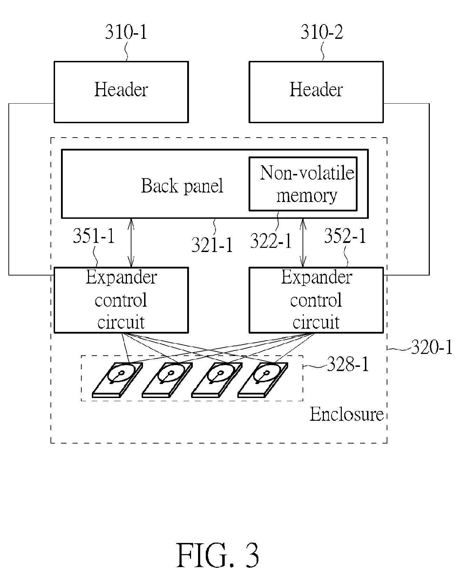

Fig. 3 is a diagram illustrating a control scheme associated with the method 200 shown in Fig. 2 according to an embodiment of the present invention. As shown in the scheme of Fig. 3, the subsystem may include the header 310-1 and the expander control circuit 351-1, and the other subsystem may include the header 310-2 and the expander control circuit 352-1, in which the main circuit 105-1 and the network module 130-1 may be installed in the header 310-1, and the main circuit 105-2 and the network module 130-2 may be installed in the header 310-2. Further, the enclosure 320-1 may include the back panel 321-1. The back panel 321-1 may include a non-volatile memory 322-1, in which the back panel 321-1 may be an example of the coupling circuit 101, and the non-volatile memory 322-1 may store a unique identification UID1, which may be an example of the characteristic parameter. Further, the enclosure 320-1 may be used to configure the expander control circuits 351-1, 352-1 and a set of hard disk drives 328-1 (which may be an example of the aforementioned set of shared storage devices), in which the expander control circuits 351-1 and 352-1 may be coupled to the headers 310-1 and 310-2 through SAS cables, respectively. A description of features in this embodiment which are similar to those in the aforementioned embodiments/modifications is omitted here for brevity.

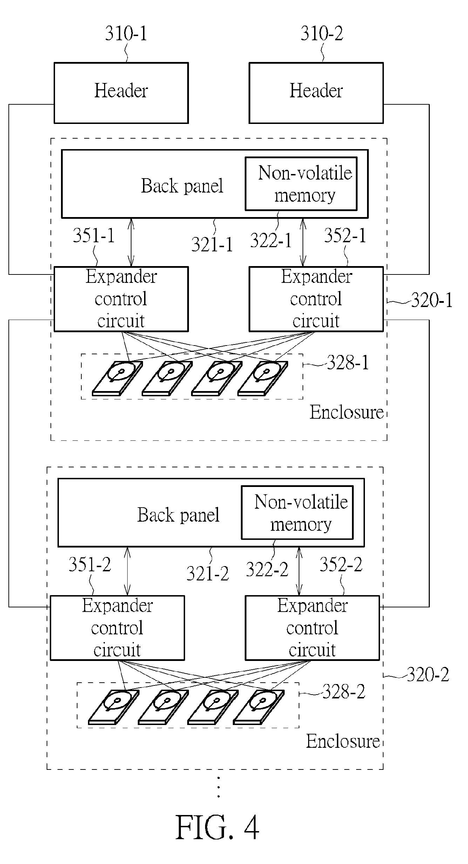

Fig. 4 is a diagram illustrating a control scheme associated with the method 200 shown in Fig. 2 according to another embodiment of the present invention, in which the scheme shown in Fig. 4 may include the scheme shown in Fig. 3. In the scheme of Fig. 4, the subsystem may further include the expander control circuit 351-2, and the other subsystem may further include the expander control circuit 352-2. Further, the enclosure 320-2 may include the back panel 321-2, and the back panel 321-2 may include the non-volatile memory 322-2, in which the back panel 321-2 may be an example of the coupling circuit 101, and the non-volatile memory 322-2 may store a unique identification UID2, which may be an example of the characteristic parameter). The enclosure 320-2 may be used to configure the expander control circuits 351-2, 352-2 and a set of hard disk drives 328-2 (which may be an example of the aforementioned set of shared storage devices), in which the expander control circuits 351-2 and 352-2 may be coupled to the expander control circuits 351-1 and 352-1 through SAS cables, respectively. Note that, in this embodiment, the number N of the enclosures 320-1, 320-2, etc. may be larger than or equal to two, and the non-volatile memory 322-n of any enclosure within the N enclosures may store a unique identification (which may be an example of the characteristic parameter), in which the symbol "n" is a positive integer within [1, N]. For example, if N=3, a non-volatile memory of another enclosure within the N enclosures may store a unique identification UID3.

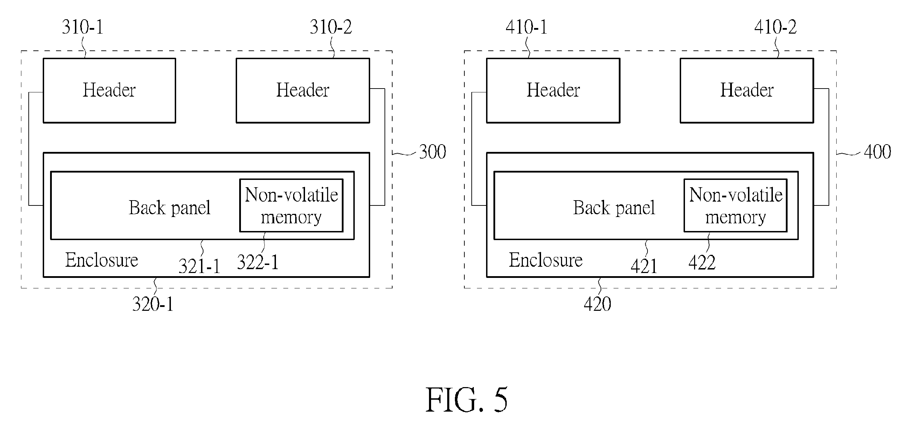

Fig. 5 is a diagram illustrating a control scheme associated with the method 200 shown in Fig. 2 according to yet another embodiment of the present invention. Any of the storage systems 300 and 400 shown in Fig. 5 may be an example of the storage system shown in Fig. 1. The implementations of the storage system 400 are similar to those of the storage system 300, in which the headers 410-1 and 410-2, enclosure 420, back panel 421, and non-volatile memory 422 may be copies of the header 310-1 and 310-2, enclosure 320-1, back panel 321-1, and non-volatile memory 322-1. The unique identification UID4 stored in the non-volatile memory 422 is different from the unique identification UID1 stored in the non-volatile memory 322-1, however. Since the unique identification UID4 is different from the unique identification UID1, any of the storage systems 300 and 400 may be automatically established as a high availability cluster, without encountering the issues of related arts mentioned above.

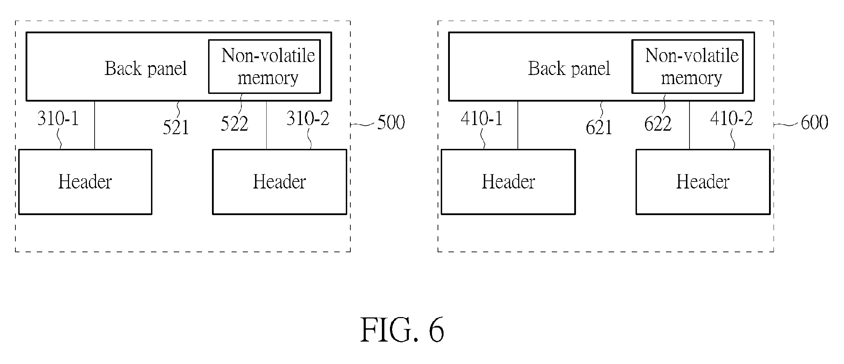

Fig. 6 is a diagram illustrating a control scheme associated with the method 200 shown in Fig. 2 according to still another embodiment of the present invention. Any of the storage systems 500 and 600 shown in Fig. 6 may be an example of the storage system shown in Fig. 1. According to this embodiment, it is not necessary to install the aforementioned coupling circuit 101 inside a specific enclosure. For example, the storage system 500 may include the headers 310-1 and 310-2 and back panel 521, and the back panel 521 may include the non-volatile memory 522 (which may store a unique identification UID5), in which the back panel 521 may be an example of the coupling circuit 101. Similarly, the storage system 600 may include the headers 410-1 and 410-2 and back panel 621, and the back panel 621 may include the non-volatile memory 622 (which may store a unique identification UID6), in which the back panel 621 may be an example of the coupling circuit 101. Since the unique identification UID6 is different from the unique identification UID5, any of the storage systems 500 and 600 may be automatically established as a high availability cluster, without encountering the related art issues mentioned above.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. An apparatus for managing a storage system, the storage system comprising a plurality of subsystems, the apparatus **characterized by**:
a main circuit (105-1), installed in a subsystem within the plurality of subsystems, and coupled to another subsystem within the plurality of subsystems through a coupling circuit of the storage system, the main circuit (105-1) arranged to control operations of the subsystem, wherein the main circuit (105-1) obtains a characteristic parameter of the coupling circuit (101) from the coupling circuit (101); and
a network module (130-1), coupled to the main circuit (105-1), the network module (130-1) arranged to provide a network service for the main circuit (105-1), wherein by utilizing the characteristic parameter, the main circuit (105-1) controls the subsystem to exchange information with said other subsystem through the network module (130-1), to automatically establish the storage system as a high availability cluster.

2. The apparatus of claim 1, **characterized in that** one of the subsystem and said other subsystem sends a packet to another of the subsystem and said other subsystem through the network module (130-1), to allow said other of the subsystem and said other subsystem to determine whether the subsystem and said other subsystem belong to a same system or not; and the packet carries the characteristic parameter of the coupling circuit (101).

3. The apparatus of claim 2, **characterized in that** the one of the subsystem and said other subsystem is the subsystem, and said other of the subsystem and said other subsystem is said other subsystem; when the subsystem boots up, the main circuit (105-1) obtains the characteristic parameter from the coupling circuit (101); said other subsystem obtains the characteristic parameter from the coupling circuit (101), and compares the characteristic parameter obtained from the coupling circuit (101) with the characteristic parameter obtained from the packet, to determine whether said other subsystem and the subsystem belong to a same system or not; and when said other subsystem determines that said other subsystem and the subsystem belong to the same system, said other subsystem sends another packet to the subsystem through the network module (130-1), to confirm whether said other subsystem and the subsystem belong to the same system or not.

4. The apparatus of claim 2, **characterized in that** the one of the subsystem and said other subsystem is said other subsystem, and said other of the subsystem and said other subsystem is the subsystem; when said other subsystem boots up, said other subsystem obtains the characteristic parameter from the coupling circuit (101) ; under the control of the main circuit (105-1), the subsystem compares the characteristic parameter obtained from the coupling circuit (101) with the characteristic parameter obtained from the packet, to determine whether the subsystem and said other subsystem belong to a same system or not; and when the subsystem determines that the subsystem and said other subsystem belong to the same system, the subsystem sends another packet to said other subsystem through the network module (130-1), to confirm whether the subsystem and said other subsystem belong to the same system or not.

5. The apparatus of claim 1, **characterized in that** the main circuit (105-1) and the network module (130-1) are located in a management module within a set of management modules of the storage system corresponding to the subsystem; and the coupling circuit (101) are located in an expander module of the storage system, wherein the expander module is arranged to install a set of shared storage devices of the storage system.

6. The apparatus of claim 5, **characterized in that** the coupling circuit (101) is a back panel of the expander module; and the apparatus comprises the expander module.

7. A method for managing a storage system, the storage system comprising a plurality of subsystems, the method applied to a subsystem within the plurality of subsystems, the subsystem coupled to another subsystem of the plurality of subsystems through a coupling circuit (101), the method **characterized by**:
utilizing a main circuit (105-1) of the subsystem to obtain a characteristic parameter of the coupling circuit (101) from the coupling circuit (101), wherein a network module (130-1) of the subsystem is coupled to the main circuit (105-1), and the network module (130-1) is arranged to provide a network service for the main circuit (105-1); and
by utilizing the characteristic parameter, controlling the subsystem to exchange information with said other subsystem through the network module (130-1), to automatically establish the storage system as a high availability cluster.

8. The method of claim 7, **characterized in that** one of the subsystem and said other subsystem sends a packet to another of the subsystem and said other subsystem through the network module (130-1), to allow said other of the subsystem and said other subsystem to determine whether the subsystem and said other subsystem belong to a same system or not; and the packet carries the characteristic parameter of the coupling circuit (101).

9. The method of claim 8, **characterized in that** the one of the subsystem and said other subsystem is the subsystem, and said other of the subsystem and said other subsystem is said other subsystem; and the step of utilizing the main circuit (105-1) of the subsystem to obtain the characteristic parameter of the coupling circuit (101) from the coupling circuit (101) further comprises:
when the subsystem boots up, utilizing the main circuit (105-1) to obtain the characteristic parameter from the coupling circuit (101), wherein said other subsystem obtains the characteristic parameter from the coupling circuit (101), and compares the characteristic parameter obtained from the coupling circuit (101) with the characteristic parameter obtained from the packet, to determine whether said other subsystem and the subsystem belong to a same system or not, wherein when said other subsystem determines said other subsystem and the subsystem belong to the same system, said other subsystem sends another packet to the subsystem through the network module (130-1), to confirm whether said other subsystem and the subsystem belong to the same system or not.

10. The method of claim 8, **characterized in that** the one of the subsystem and said other subsystem is said other subsystem, and said other of the subsystem and said other subsystem is the subsystem; when said other subsystem boots up, said other subsystem obtains the characteristic parameter from the coupling circuit (101) ; and the step of utilizing the main circuit (105-1) of the subsystem to obtain the characteristic parameter of the coupling circuit (101) from the coupling circuit (101) further comprises:
utilizing the main circuit (105-1) to compare the characteristic parameter obtained from the coupling circuit (101) with the characteristic parameter obtained from the packet, to determine whether the subsystem and said other subsystem belong to a same system or not; and
when the subsystem determines that the subsystem and said other subsystem belong to the same system, utilizing the main circuit (105-1) to control the subsystem to send another packet to said other subsystem through the network module (130-1), to confirm whether the subsystem and said other subsystem belong to the same system or not.

11. The method of claim 7, **characterized in that** the step of utilizing the main circuit (105-1) of the subsystem to obtain the characteristic parameter of the coupling circuit (101) from the coupling circuit (101) further comprises:
when the subsystem boots up, utilizing the main circuit (105-1) to obtain the characteristic parameter from the coupling circuit (101) ;
wherein the step of utilizing the main circuit (105-1) to control the subsystem to exchange information with said other subsystem through the network module (130-1) to automatically establish the storage system as the high availability cluster further comprises:
utilizing the main circuit (105-1) to trigger the subsystem to automatically establish the high availability cluster according to the characteristic parameter.

12. The method of claim 7, **characterized in that** the step of utilizing the main circuit (105-1) of the subsystem to obtain the characteristic parameter of the coupling circuit (101) from the coupling circuit (101) further comprises:
in response to the trigger of said other subsystem, utilizing the main circuit (105-1) to obtain the characteristic parameter from the coupling circuit (101) ;
wherein the step of utilizing the main circuit (105-1) to control the subsystem to exchange information with said other subsystem through the network module (130-1) to automatically establish the storage system as the high availability cluster further comprises:
utilizing the main circuit (105-1) to response to said other subsystem according to the characteristic parameter, to automatically establish said other subsystem as the high availability cluster according to the characteristic parameter.

13. The apparatus of claim 2 or the method of claim 8, **characterized in that** the packet is a broadcast packet or a multicast packet.

14. The apparatus of claim 1 or the method of claim 7, **characterized in that** the coupling circuit (101) comprises a non-volatile memory, and the non-volatile memory stores a unique identification; and the characteristic parameter comprises the unique identification.

15. The apparatus of claim 1 or the method of claim 7, **characterized in that** the characteristic parameter comprises the coupling circuit (101) serial number.
